# EUROPEAN PATENT APPLICATION

(11) **EP 2 720 525 A1**
(43) Date of publication of application: **16.04.2014**
(21) Application number: 11867532.1
(22) Date of filing: 08.06.2011
(51) Int. Cl.: H05K 9/00, H05K 3/40

(54) **SURFACE MOUNTING GASKET AND METHOD OF MANUFACTURING SAME**

(71) Applicant: Choi, Chul Soo, Busan 612-040 (KR)
(72) Inventor: Choi, Chul Soo, Busan 612-040 (KR)
(74) Representative: Melin Granberg, Linda
(86) International application number: PCT/KR2011/004211
(87) International publication number: WO 2012/169674

(57) **Abstract**

Disclosed are a surface mount gasket and a method of manufacturing the same. The surface mount gasket includes a laminated sheet comprising a solderable metal layer and a core layer adjoining one surface of the metal layer, and a plating layer surrounding the laminated sheet.

## Description

### [Technical Field]

The present invention relates to a surface mount gasket and a method of manufacturing the same. More particularly, the present invention relates to a surface mount gasket, which has excellent conductivity, facilitates soldering and reduces manufacturing costs, and a method of manufacturing the same.

### [Background Art]

In general, electromagnetic noise is generated by electrostatic discharge, occurring in internal circuits of various electronic devices and propagating outside through air or being transmitted through a power cable or the like. Electromagnetic radiation is known not only to cause noise in and malfunction of peripheral parts or devices, but also to be harmful to the human body. As electronic devices have recently become lighter, thinner, simpler and smaller, increasingly complex circuits are used, increasingly complex circuits are used and increase sensitivity to electromagnetic noise, and regulations concerning electromagnetic radiation have been tightened in many countries. In particular, electromagnetic interference (EMI) causes many problems due to electromagnetic radiation generated from a joint between parts or from a door gap of various electronic devices. Accordingly, an electromagnetic shielding gasket has generally been used to shield electromagnetic radiation generated in the joint or the door gap.

In particular, for a printed circuit board (PCB) or a flexible printed circuit board (FPCB), electrostatic discharge or electromagnetic interference (EMI) can cause device failure. To effectively remove such electrostatic discharge or electromagnetic interference (EMI), an electrically conductive grounding gasket is used.

An electrically conductive gasket for mounting printed circuit boards is required to have excellent conductivity, solderability, heat-resistance, and elastic restoration.

In the related art, a beryllium copper sheet is used for a grounding terminal. To this end, the beryllium copper sheet is punched and bent into a predetermined shape through pressing, followed by heat treatment and surface treatment. However, an electric contact terminal made only of a metal sheet provides low elasticity to an electric contact terminal at a predetermined height or less due to metallic and structural characteristics thereof. That is, it is necessary to bend the metal sheet into a predetermined shape in order to provide elasticity to the metal sheet, and the height of the electric contact terminal generally depends on the bending height. Therefore, it is difficult to provide elasticity to the electric contact terminal at a predetermined height or below. In addition, there are disadvantages that a press mold must be manufactured corresponding to the dimensions (size) of the grounding terminal, the height of the grounding terminal can be deformed during heat treatment, and another press mold is needed to manufacture a product of a different shape since each press mold can only be used to produce products of the same shape.

Korean Patent Publication No. 2001-42299A discloses a technique in which conductive metal powder is mixed with silicone for extrusion into a conductive silicone rubber and a copper film is attached to one side thereof. However, this method has problems in that resistance, adherence or elasticity can be deteriorated according to the amount of metal powder, and manufacturing costs are increased due to use of expensive silver.

Korean Patent No. 783588 discloses a method of manufacturing an elastic electric contact terminal using a polyimide film. This method has a problem in that adhesion between the polyimide film and a metal layer is so low that a metal film may be separated at high temperature.

In one method used in the art, a plating layer is formed on surfaces of electrically conductive fibers and attached to an elastic core. However, this method has a problem in that the conductive fibers may be burned during a soldering process at 250°C or more.

As such, when the metal layer or plating layer is formed by attachment, there are problems, such as a difficult manufacturing process and low durability due to deterioration in adhesion to the elastic core. Moreover, since the entire surface of the elastic core is not surrounded, short-circuit can occur.

Furthermore, in the related art, a separate gap must be formed for soldering, and a small gap area can provide low productivity due to difficulty in soldering.

To solve such problems, the present inventor developed a surface mount gasket and a method of manufacturing the same, in which a solderable metal layer and a core layer are stacked, cut and plated, thereby facilitating a manufacturing process while providing good conductivity and lower manufacturing costs.

### [Disclosure]

### [Technical Problem]

It is an aspect of the present invention to provide a surface mount gasket having excellent electric conductivity, and a method of manufacturing the same.

It is another aspect of the present invention to provide a surface mount gasket, which can be easily manufactured at reduced manufacturing costs, and a method of manufacturing the same.

It is a further aspect of the present invention to provide a surface mount gasket, which allows easy adjustment of the dimensions and height thereof, and a method of manufacturing the same.

It is yet another aspect of the present invention to provide a surface mount gasket, which prevents short circuit and has excellent durability, and a method of manufacturing the same.

It is yet another aspect of the present invention to provide a surface mount gasket, which has excellent shielding and grounding effects and serves as a countermeasure against electromagnetic interface (EMI)/electrostatic discharge (ESD), and a method of manufacturing the same.

It is yet another aspect of the present invention to provide a surface mount gasket, which reduces manufacturing costs, has uniform quality and permits mass production, and a method of manufacturing the same.

It is yet another aspect of the present invention to provide a surface mount gasket, in which soldering is possible without formation of a separate gap, and a method of manufacturing the same.

It is yet another aspect of the present invention to provide a surface mount gasket, which has excellent adhesion and is easily soldered since the entire surface of a metal layer is used for soldering, and a method of manufacturing the same.

Technical problems to be solved by the present invention are not limited to what has been described above and other technical problems not described above will be readily understood by those skilled in the art from the following descriptions.

### [Technical Solution]

One aspect of the present invention relates to an electrically conductive gasket. The conductive gasket includes a laminated sheet including a solderable metal layer and a core layer adjoining one surface of the metal layer and a plating layer surrounding the laminated sheet.

In one embodiment, the metal layer may be selected from copper, nickel, gold, silver, tin, iron, aluminum, and alloys thereof.

In one embodiment, the core layer may include rubber, silicone, thermoplastic or thermosetting resins.

In one embodiment, the core layer may include an expanded elastic sheet, a non-expanded elastic sheet, or combination thereof.

In one embodiment, the core layer may include multiple layers in which two or more kinds of elastic sheets are stacked. Preferably, the core layer has a multilayer structure in which non-expanded elastic sheets are stacked.

In one embodiment, the core layer may include a polymer foam sheet layer having a closed cell structure.

In one embodiment, the plating layer may include at least one metal selected from the group consisting of tin, aluminum, copper, nickel, cobalt, black nickel, silver, gold, platinum, palladium, and chromium.

Another aspect of the present invention relates a method of manufacturing a surface mount gasket. The method may include forming a laminated sheet by attaching a core layer to one surface of a solderable metal layer; cutting the laminated sheet; and plating the cut laminated sheet.

The metal layer may be selected from among copper, nickel, gold, silver, tin, iron, aluminum, or alloys thereof.

The core layer may include rubber, silicone, thermoplastic resin or thermosetting resin.

In one embodiment, the core layer may include a single layer or multiple layers.

The plating layer may include at least one metal selected from the group consisting of tin, aluminum, copper, nickel, cobalt, black nickel, silver, gold, platinum, palladium, and chromium.

### [Advantageous Effects]

In accordance with the present invention, there are provided a surface mount gasket and a method of manufacturing the same, which has excellent electric conductivity, which can be easily manufactured and reduce manufacturing costs, which allows easy adjustment of the dimensions and height thereof, prevents short circuit and has excellent durability, has excellent shielding and grounding effects and serves as a countermeasure against electromagnetic interface (EMI)/electrostatic discharge (ESD), and which reduces manufacturing costs, has uniform quality and can be mass produced.

### [Description of Drawings]

Fig. 1 is a schematic perspective view of a laminated sheet used in a surface mount gasket according to one embodiment of the present invention.
Fig. 2 is a sectional view of the surface mount gasket according to the embodiment of the present invention.
Fig. 3 is a schematic view of the surface mount gasket.
Fig. 4 is a flowchart of a method of manufacturing a surface mount gasket according to one embodiment of the present invention.
Fig. 5 is a graph depicting compressive force and resistance according to compression rate of a surface mount gasket prepared in Example 1.
Fig. 6 is a graph depicting compressive force and resistance according to compression rate of a surface mount gasket prepared in Example 2.

### [Best Mode]

### Surface mount gasket

A surface mount gasket according to the present invention includes: a laminated sheet including a solderable metal layer and a core layer adjoining one surface of the metal layer; and a plating layer surrounding the laminated sheet.

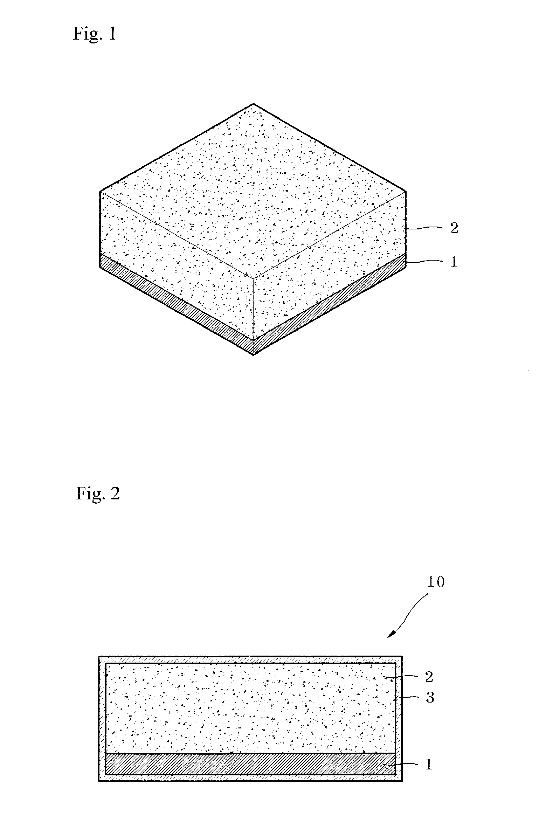

Fig. 1 is a schematic perspective view of a laminated sheet used in a surface mount gasket according to one embodiment of the invention. As shown in Fig. 1, the laminated sheet includes the solderable metal layer 1 and a core layer 2 adjoining one surface of the metal layer.

For the metal layer 1, any metal may be used so long as the metal is solderable. In one embodiment, copper, nickel, gold, silver, tin, iron, aluminum, and the like may be used as the metal layer 1. These may be used alone or as an alloy thereof.

The metal layer 1 may have a thickness of 20 µm to 300 µm, preferably a thickness of 50 µm to 150 µm.

The core layer 2 provides elasticity to the gasket, and any material may be used as the core layer 2 so long as the material has elasticity. In one embodiment, the core layer 2 may include rubber, silicone, thermoplastic resin or thermosetting resin. The rubber may include natural rubber or synthetic rubber. The thermoplastic resins may include polyolefin such as polyethylene, polypropylene, polybutylene, and the like; polyesters; acrylate polymers; ethylvinylacetate (EVA) copolymers; polyamides; styrene polymers; acetals; polycarbonates; polyurethanes; copolymers thereof; and mixtures thereof. The thermosetting resins may include polyurethanes, epoxy resins, melanin, unsaturated polyesters, and the like. Among these, a polyurethane resin is preferable.

In one embodiment, the core layer 2 may have a foam shape or a film shape. In addition, the core layer 2 may have an expanded structure or a non-expanded structure. Preferably, the core layer 2 has a micro-expanded structure in order to facilitate a cutting process.

In one embodiment, the core layer 2 may be a single layer or multiple layers. By way of example, the core layer 2 may have a structure in which micro-expanded elastic sheets are stacked into multiple layers.

In one embodiment, the core layer may include an expanded elastic sheet, a non-expanded elastic sheet, or combination thereof. In one embodiment, the core layer may have a laminated structure in which non-expanded elastic sheets are stacked into multiple layers.

The core layer 2 may have a thickness of 0.05 mm to 20 mm, preferably a thickness of 0.1 mm to 10 mm. Here, the thickness of the core layer 2 may vary depending on application.

The metal layer 1 and the core layer 2 may be stacked by a conventional bonding method, without being limited thereto. The metal layer 1 and the core layer 2 may be attached via a conventional adhesive or bonding agent.

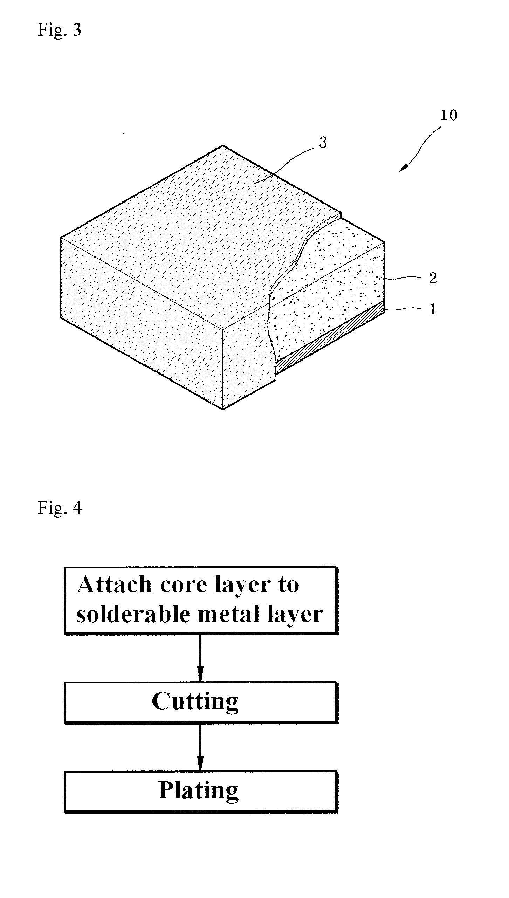

Fig. 2 is a sectional view of the surface mount gasket according to the embodiment of the present invention, and Fig. 3 is a schematic view of the surface mount gasket.

In this invention, the conductive gasket includes a plating layer 3, which surrounds the laminated sheet having the solderable metal layer 1 and the core layer 2 adjoining one surface of the metal layer 1.

The plating layer 3 contacts both the metal layer 1 and the core layer 2 since the laminated sheet is plated with the plating layer 3. In addition, since the plating layer is formed by plating, a plating solution infiltrates a foam when the core layer is a foam material, thereby forming the plating layer on a surface of a strut, a knot, and the like, which forms the foam material.

The plating layer 3 may include any metal so long as the metal can be used for plating and has electrical conductivity. In one embodiment, the plating layer may be formed of tin, aluminum, copper, nickel, cobalt, black nickel, silver, gold, platinum, palladium, chromium, or alloys thereof, without being limited thereto.

Further, the plating layer 3 may be a single layer or multiple layers of two or more materials. In one embodiment, the plating layer may be a nickel-copper-nickel plated layer, which is formed by sequentially plating nickel, copper and nickel.

### Method of manufacturing surface mount gasket

Another aspect of the present invention relates to a method of manufacturing a surface mount gasket. Fig. 4 is a flowchart of a method of manufacturing a surface mount gasket according to one embodiment of the present invention. First, the core layer is attached to one surface of the solderable metal layer, thereby forming the laminated sheet. At this time, the core layer may be a single layer or multiple layers of many folds. Here, the thickness of the core layer may be properly selected in accordance with application of the gasket.

The core layer and the metal layer may be attached by a conventional method.

The laminated sheet including the core layer and the metal layer is cut to a proper size. Cutting may be performed in a direction perpendicular to a plane on which the core layer and the metal layer are stacked. Further, the laminated sheet may be cut to a desired size and a desired shape, such as a rectangular shape, circular shape, triangular shape, elliptical, cylindrical shape, bar shape, plate shape, and the like.

After cutting, the laminated sheet is subjected to plating, and thus a plating layer is formed over the entire surface including the top, bottom and lateral surfaces of the laminated sheet. Plating may include dry plating, wet plating, or combination thereof. In addition, plating may include electroless plating or electrolytic plating, and may be easily carried out by those skilled in the art. In this embodiment, the surface of the laminated sheet is plated as above, thereby eliminating a need for a separate thin metal film, preventing quality deterioration or defects at high temperature, and reducing manufacturing costs.

A release paper sheet may be attached to at least one surface of the surface mount gasket manufactured as above. The release paper sheet may be attached by adhesives, bonding agents, and the like, without being limited thereto.

The conductive gasket according to the invention has a volume resistance (in a thickness direction) of 0.001 Ω to 1 Ω, preferably 0.01 Ω to 0.1 Ω, as measured on a sample having a size of 3x3 mm², and thus has excellent conductivity.

The present invention will be explained in more detail with reference to some examples. It should be understood that these examples are provided for illustration only and are not to be in any way construed as limiting the invention.

### [Mode for Invention]

### Example 1

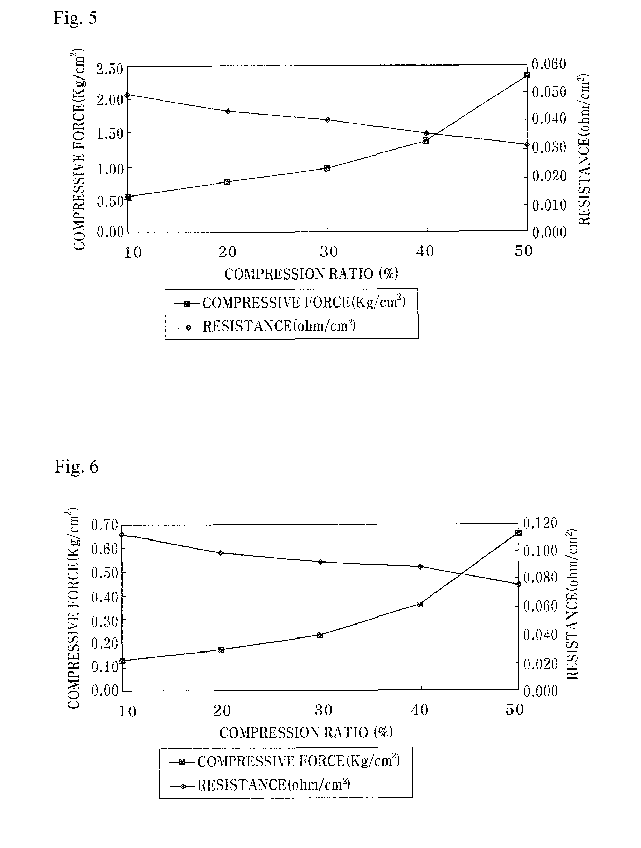

A 3.2 mm thick polyurethane foam material was used as a core layer and attached to a 100 µm thick copper film using a thermosetting bonding agent to prepare a laminated sheet of 3.3 mm thick, which in turn was cut to have an area of 4 x 6 mm². Then, the cut laminated sheet was sequentially plated with nickel, copper and nickel by electroless plating, thereby preparing 1,000 surface mount gasket samples. Compressive force and resistance of the samples having a size of 4 mm (W) x 3.3 mm (H) x 6 mm (L) according to compression ratio were measured 15 times, and an average thereof was obtained. Measurement results are shown in Table 1 and Fig. 5.

**Table 1**

| Compression ratio (%) | Compressive force (Kgf) | Resistance (ohm) |
|---|---|---|
| 10 | 0.13 | 0.023 |
| 20 | 0.27 | 0.015 |
| 30 | 0.45 | 0.009 |
| 40 | 0.58 | 0.006 |
| 50 | 0.94 | 0.004 |

### Example 2

A 1.2 mm thick polyurethane foam material was used as a core layer and attached to a 100 µm thick copper film using a thermosetting bonding agent to prepare a laminated sheet of 1.3 mm thick, which in turn was cut to have an area of an area of 2 x 8 mm². Then, the cut laminated sheet was sequentially plated with nickel, copper and nickel by electroless plating, thereby manufacturing 1,000 surface mount gasket samples. Compressive force and resistance of the samples having a size of 2 mm (W) x 1.3 mm (H) x 8 mm (L) according to compression ratio were measured 15 times, and an average thereof was obtained. Measurement results are shown in Table 2 and Fig. 6.

**Table 2**

| Compression ratio (%) | Compressive force (Kgf) | Resistance (ohm) |
|---|---|---|
| 10 | 0.15 | 0.040 |
| 20 | 0.20 | 0.010 |
| 30 | 0.27 | 0.003 |

### Comparative Example 1

A 50 µm thick polyimide film coated with a bonding agent was plated with copper and nickel and attached to an outer surface of a silicone core, and the core including the metal-plated film was cut to a length of 6.0 mm, thereby preparing samples. Compressive force and resistance of the samples according to compression ratio were measured 15 times, and an average thereof was obtained.

According to the measurement results, the samples prepared in Example 1, which were prepared through a simpler process, exhibited better conductivity than Comparative Example 1. Accordingly, the surface mount gaskets of the present invention have improved productivity, can reduce manufacturing costs, and have excellent conductivity and uniform quality.

It will be apparent by those skilled in the art that various modifications, variations, and alterations can be made without departing from the spirit and scope of the present invention.

## Claims

1. A surface mount gasket comprising:
a laminated sheet comprising a solderable metal layer and a core layer adjoining one surface of the metal layer; and
a plating layer surrounding the laminated sheet.

2. The surface mount gasket according to claim 1, wherein the metal layer is selected from among copper, nickel, gold, silver, tin, iron, aluminum, and alloys thereof.

3. The surface mount gasket according to claim 1, wherein the core layer comprises rubber, silicone, thermoplastic resin or thermosetting resin.

4. The surface mount gasket according to claim 3, wherein the core layer comprises an expanded elastic sheet, a non-expanded elastic sheet, or combination thereof.

5. The surface mount gasket according to claim 1, wherein the core layer comprises multiple layers in which elastic sheets are stacked.

6. The surface mount gasket according to claim 1, wherein the core layer comprises a polymer foam sheet layer having a closed cell structure.

7. The surface mount gasket according to claim 1, wherein the plating layer comprises at least one metal selected from the group consisting of tin, aluminum, copper, nickel, cobalt, black nickel, silver, gold, platinum, palladium, and chromium.

8. A method of manufacturing a surface mount gasket, comprising:
forming a laminated sheet by attaching a core layer to one surface of a solderable metal layer;
cutting the laminated sheet; and
plating the cut laminated sheet to form a plating layer.

9. The method according to claim 8, wherein the metal layer is selected from among copper, nickel, gold, silver, tin, iron, aluminum, and alloys thereof.

10. The method according to claim 8, wherein the core layer comprises rubber, silicone, thermoplastic or thermosetting resins.

11. The method according to claim 8, wherein the core layer comprises a single layer or multiple layers.

12. The method according to claim 8, wherein the plating layer comprises at least one metal selected from the group consisting of tin, aluminum, copper, nickel, cobalt, tin, black nickel, silver, gold, platinum, palladium, and chromium.
